# EUROPEAN PATENT SPECIFICATION

(11) **EP 2 672 508 B1**
(45) Date of publication and mention of the grant of the patent: **05.06.2019**
(21) Application number: 12742138.6
(22) Date of filing: 24.01.2012
(51) Int. Cl.: H01L 21/20, H01L 27/12, H01L 21/762

(54) **METHOD FOR MANUFACTURING SOI WAFER**
VERFAHREN ZUR HERSTELLUNG EINES SOI-WAFERS
PROCÉDÉ DE FABRICATION DE TRANCHE DE SILICIUM SUR ISOLANT (SOI)

(30) Priority: 02.02.2011 JP 2011020706
(43) Date of publication of application: 11.12.2013
(73) Proprietor: Shin-Etsu Chemical Co., Ltd., Tokyo 100-0004 (JP)
(72) Inventor: AKIYAMA, Shoji, Annaka-shi Gunma 379-0195 (JP)
(74) Representative: Vidon Brevets & Stratégie
(86) International application number: PCT/JP2012/051412
(87) International publication number: WO 2012/105367

(56) References cited:
- JP-A- 8 250 421
- JP-A- 63 226 914
- JP-A- 2003 324 188
- US-A1- 2009 269 906
- US-A1- 2010 248 444
- DONOVAN E P ET AL: "Heat of crystallization and melting point of amorphous silicon", APPLIED PHYSICS LETTERS, AMERICAN INSTITUTE OF PHYSICS, US, vol. 42, no. 8, 15 April 1983 (1983-04-15) , pages 698-700, XP002475236, ISSN: 0003-6951, DOI: 10.1063/1.94077

## Description

### Technical Field

The present invention relates to a method for manufacturing a SOI wafer.

### Background Art

Silicon-on-insulator (SOI) wafers have come into widespread use to achieve reduced parasitic capacitance and increased speed of devices. Among the SOI wafers, silicon on quartz (SOQ) and silicon on sapphire (SOS), each comprising an insulating transparent wafer as a handle wafer, have been attracting attention. The SOQ is expected to be applied to an optoelectronic field, in which the high transparency of quartz is utilized, or to high-frequency devices making use of the low dielectric loss thereof. The SOS wafer comprising sapphire as a handle wafer has a high thermal conductivity, which is not available with quartz, in addition to high transparency and low dielectric loss, so that the SOS is expected to be applied to high-frequency devices that generate heat.

To laminate a single crystal having a high quality, a silicon film is ideally produced from a bulk silicon wafer by a bonding and transferring method. There have been developed a method for heteroepitaxially growing a silicon layer on a round sapphire surface, and CG silicon produced by growing non-single-crystal silicon on glass and then enhancing its crystallinity by laser annealing. However, it may be said that no other methods are as good as a bonding method.

There is a problem, however, in that a SOITEC method extensively used for fabricating SOI wafers cannot be used to fabricate the wafers of SOQ, SOS and the like, because different types of materials having significantly different coefficients of thermal expansion are to be bonded.

According to the SOITEC method, after two wafers are bonded, they need to be subjected to a heat treatment at 450°C to 500°C to enhance the bonding strength. In the SOI comprising silicon as a handle substrate thereof, two silicon wafers are bonded without any problems. SOQ and SOS wafers, however, cause a problem in that bonded wafers crack when subjected to a heat treatment. The coefficients of thermal expansion of silicon, quartz and sapphire are 2.6×10⁻⁶/K, 0.56×10⁻⁶/K, and 5.8×10⁻⁶/K, respectively.

A method for avoiding the aforesaid problem has been generally known, in which surface activation treatment is carried out before bonding, and a heat treatment at a relatively low temperature is carried out after the bonding to obtain a high bonding strength (refer to, for example, Non-Patent document 1).

### Prior art document(s)

### Non-Patent document(s)

Non-patent document 1: G. L. Sun, J. Zhan, Q. Y. Tong, S. J. Xie, Y. M. Cai, and S. J. Lu, "Cool plasma activated surface in silicon direct bonding technology," J. de Physique, 49 (C4), 79 (1988)

### Summary of the Invention

### Problems to be solved by the Invention

However, even in the SOQ and SOS fabricated by the aforesaid low-temperature treatment, defects (pits, minute cracks or the like) that have been induced and developed by a stress or the like during the process remain in the silicon layer thereof, and these defects may adversely affect the characteristics of devices. It is difficult to obtain a single-crystal silicon layer equivalent to that of a commercially available SOI wafer.

Furthermore, if an ion implantation method is adopted to form a single-crystal silicon layer in the bonding method, then the surface of the single-crystal silicon layer formed after separation is susceptible to damage.

It is generally well known that a heat treatment is carried out to repair the damage caused by ion implantation or the like. For example, there is a separation by ion implantation of oxygen (SIMOX) method in which oxygen ions are implanted into a silicon wafer and then heat of a high temperature (approximately 1300°C) is applied over an extended time. However, this method requires a long-time (6 hours to 12 hours) and high-temperature process, whereas quartz does not survive the temperature (the glass-transition temperature is approximately 1050°C). Although sapphire exhibits high heating resistance, the diffusion of aluminum from sapphire may result from the application of a heat treatment at 900°C or above for a long time.

The present invention has been made in view of such circumstances, and an object of the invention provides a method for reducing defects incurred on a surface of and inside a single-crystal silicon layer by a bonding method by a treatment at a relatively low temperature over a relatively short time.

US 2009/269906 A1 discloses a method of making silicon on insulator (e.g. silicon on sapphire, silicon on quartz etc.) process by layer transfer (bonding). To cure defects (e.g. roughness, pinholes) in the film due to the layer transfer step, an amorphous silicon film is deposited and subsequently annealed. In paragraph [0058]-[0060] US 2009/269906 A1 teaches a deposition temperature of 200-400°C.

US 2010/248444 A1 also discloses an SOI wafer made by layer transfer (smart cut) process. To cure defects (e.g. roughness, pinholes) in the film due to the layer transfer step, an amorphous silicon film is deposited and subsequently annealed. In paragraph [0054] US 2010/248444 A1 teaches an amorphous silicon deposition temperature of 100-300°C.

JPH08250421 also discloses an SOI wafer made by layer transfer (smart cut) process. To cure defects (e.g. roughness, pinholes) in the film due to the layer transfer step, an amorphous silicon film is deposited and subsequently annealed. In paragraph [0018] JPH08250421 teaches an amorphous silicon deposition temperature of 250°C to 350°C.

### Means for solving the Problems

To solve the problem, the inventor has devised the following method.

A method for manufacturing a bonded substrate in accordance with the present invention comprises the steps of: forming a single-crystal silicon layer by a bonding method on a handle substrate, which is selected from a material having a heat-resistant temperature of 800°C or above, thereby to obtain a bonded substrate; depositing amorphous silicon on the single-crystal silicon layer of the bonded substrate at a temperature of 540°C to 600°C; and heating the bonded substrate after the depositing at 800°C or above.

### Advantageous effect of the Invention

The method for manufacturing a bonded substrate in accordance with the present invention makes it possible to reduce, by a treatment of a relatively low temperature over a relatively short time, defects incurred on a surface of and inside a single-crystal silicon layer by a bonding method in a bonded substrate such as SOQ or SOS, comprising silicon and a material having a significantly different coefficient of thermal expansion from silicon.

### Brief description of the Drawings

[FIG. 1] It is a schematic process diagram illustrating a method in accordance with the present invention.
[FIG. 2] It is a graph illustrating the dependence of the density of defects on an annealing temperature in the case where the method in accordance with the present invention is applied to an SOQ wafer.
[FIG. 3] It is a graph illustrating the dependence of the density of defects on an annealing temperature in the case where the method in accordance with the present invention is applied to an SOS wafer.
[FIG. 4] It is a graph comparing the densities of defects in the case where amorphous silicon or polysilicon is applied to the SOQ wafer and annealed in Comparative Example 3.
[FIG. 5] It is a graph comparing the densities of defects in the case where amorphous silicon or polysilicon is applied to the SOS wafer and annealed in Comparative Example 4.

### Modes for carrying out the Invention

The following will explain the present invention in detail with reference to the accompanying drawings. The like members are assigned like reference numerals. The present invention is not limited to the embodiments explained below.

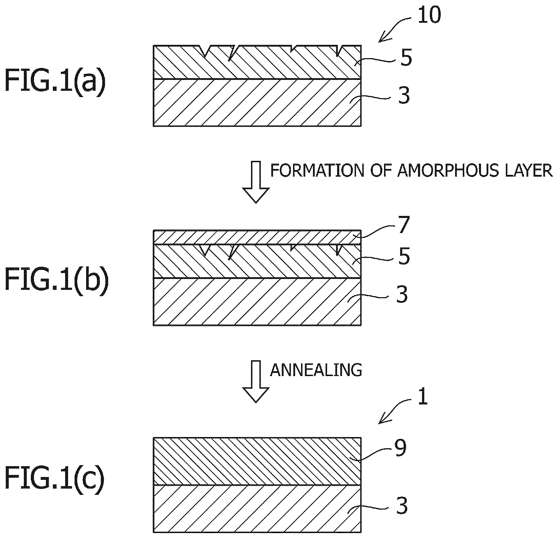

A series of steps of the method in accordance with the present invention is illustrated in FIG. 1.

First, by using a bonding method, a bonded substrate 10 in which a single- crystal silicon layer 5 is formed on a handle substrate 3 of a material having a heat-resistant temperature of 800°C or higher, such as sapphire or quartz, is prepared (step a).

The method for manufacturing a bonded substrate is not limited to any specific methods. After a handle substrate and a single-crystal silicon substrate are bonded, the following methods, for example, may be used to obtain the bonded substrate: (1) a method in which a heat treatment is carried out at approximately 500°C in an inert gas atmosphere and then thermal separation is caused by a crystalline rearrangement effect and the aggregation effect of implanted hydrogen bubbles; (2) a method in which a temperature difference between the two surfaces of the bonded substrate is caused for separation along a hydrogen ion implantation interface; or (3) a method in which, after hydrogen ions (H⁺) or hydrogen molecular ions (H₂⁺) are implanted into a single-crystal silicon from a surface thereof, the surface of the single-crystal silicon or a surface of a handle substrate is subjected to an ozone water treatment, a UV ozone treatment, an ion beam treatment or a plasma treatment as an activation treatment for bonding, and then mechanical separation and/or light irradiation separation (preferably, a laser light of 400 nm to 700 nm, or a halogen lamp light or xenon lamp light having a maximum intensity in 400 nm to 700 nm) is carried out.

A material having a heat resistant temperature of 800°C or higher refers to a material that does not develop a significant deformation after being subjected to the heat treatment of 800°C. An amorphous material, such as quartz, may be selected based on a glass-transition temperature or the like (the glass-transition temperature of quartz being approximately 1050°C) instead of the heat resistant temperature. A crystal material, such as sapphire, may be selected based on a melting point (the melting point of sapphire being approximately 2050°C) instead of the heat resistant temperature.

The handle substrate 3 may be either transparent or opaque in a visible light range (400 nm to 700 nm) and may include the sapphire and quartz mentioned above, silicon, silicon with an oxide film, silicon carbide, and aluminum nitride.

The preferable thickness of the single-crystal silicon layer 5 may be, for example, 20 nm to 500 nm in the case where the layer 5 is to be subjected to a polishing step described later, taking a polishing allowance into account, or may be 50 nm to 600 nm in the case where the layer 5 is not to be subjected to the polishing step.

In the case where the bonding method is adopted, a damaged layer of approximately 150 nm remains on the surface of the single-crystal silicon layer 5, so that CMP polishing is preferably carried out before depositing an amorphous silicon layer 7, which will be described later. Removing the whole damaged layer by polishing would increase variations in the film thickness. Hence, it is reasonable to use, in an actual process, a method comprising a step of removing most of the damaged layer by chemical etching and then a step of mirror-polishing the rest of the damaged layer to a mirror finish. It is important to remove the damaged layer on the surface as much as possible. The effectiveness of the present invention has been empirically proven to be independent of the method for removing the damaged layer (the CMP, etching or the combination of the former two).

The CMP polishing is carried out to provide a surface with a mirror finish, and the surface is generally subjected to polishing of 30 nm or more.

After the CMP polishing and the mirror polishing described above, cleaning by a wet process, such as RCA cleaning or spin cleaning, and/or cleaning by a dry process, such as UV/ozone cleaning or HF vapor cleaning, may be carried out.

Defects remain in the single-crystal silicon layer 5 of the bonded substrate 10 obtained by the steps described above. Therefore, the amorphous silicon 7 is deposited on the single-crystal silicon layer 5 (step b). The method for depositing the amorphous silicon 7 is not limited to any particular method. Because of its capability of processing 100 to 200 wafers at a time, the low pressure chemical vapor deposition (LPCVD) process, for example, is considered to be advantageous from the viewpoint of cost. Alternatively, the sputtering process (PVD) or the plasma enhanced chemical vapor deposition (PECVD) process may be reasonably used.

It is important in this case that the layer, which becomes an underlayer, is made of the single-crystal silicon formed by the bonding method and the silicon layer formed thereon preferably is completely amorphous (non-crystalline). If the silicon to be deposited contains polysilicon (polycrystal), then the process will not be successful because minute crystals exist in random directions in the deposited layer. The temperature at the time of the deposition is 600°C or below so as to prevent the formation of a polysilicon layer.

A further preferable upper limit of the temperature is 580°C. A lower limit of the temperature is 540°C. The thickness of the amorphous silicon to be deposited is preferably in the range of 20 nm to 500 nm.

The type of gas to be used is not limited to any particular type. For example, SiH₄ or the like is used for the LPCVD process or the PECVD process. For the sputtering (PVD) process, a silicon target can be used.

Depending on the type of gas, the film forming pressure is approximately 200 mTorr in the case of the LPCVD.

Thereafter, the bonded substrate after the step of depositing is heated at 800°C or above to cause the amorphous silicon layer 7 to crystallize and turn into a single-crystal silicon coating layer 9 together with the single-crystal silicon layer 5 (step c). In this step, defects such as pits or minute cracks which are present in the surface of the single-crystal silicon layer 5 are buried (repaired), thus reducing a number of defects.

The preferable upper limit of the heating temperature is determined, considering the heat resistance of the handle substrate, and may be set to below approximately 1200°C in the case where the handle substrate is made of quartz or may be set to below approximately 1300°C in the case where the handle substrate is made of sapphire.

The period of heating may be, for example, 0.5 hours to 6 hours in view of mainly restraining the migration of atoms contained in the handle substrate.

In the method according to the present invention, the single-crystal silicon layer 5, which becomes the underlayer, and the amorphous silicon layer 7 are distinctly separated. This causes the amorphous silicon layer 7 to easily crystallize in accordance to the orientation of the single-crystal silicon layer 5, which becomes the underlayer, thus making it possible to obtain the single-crystal silicon coating layer 9 having a high quality at a relatively low temperature (800°C to 1200°C).

### Examples

### (Comparative Example 1)

An SOQ wafer fabricated by the bonding method was prepared. The thickness of the single-crystal silicon layer was set to 100 nm. The diameter of the wafer was 150 mm and the thickness thereof was 625 µm. The wafer was immersed for 5 minutes in a 49-percent hydrogen fluoride (HF) solution and then rinsed with pure water. The number of defects in a section of 3.0 mm × 3.0 mm was visually counted under an optical microscope (having a magnification of 50 power). On the average (13 places observed in the surface), 6.5 defects/cm² were found.

### (Comparative Example 2)

An SOS wafer fabricated by the bonding method was prepared. The thickness of the single-crystal silicon layer was set to 100 nm. The thickness of a buried oxide (SiO₂, BOX layer) was set to 200 nm. The diameter of the wafer was 150 mm and the thickness thereof was 600 µm. The wafer was immersed for 5 minutes in a 49-percent hydrogen fluoride (HF) solution and then rinsed with pure water. The number of defects was counted under the optical microscope. On the average (13 places observed in the surface), 14.1 defects/cm² were found.

### (Example 1)

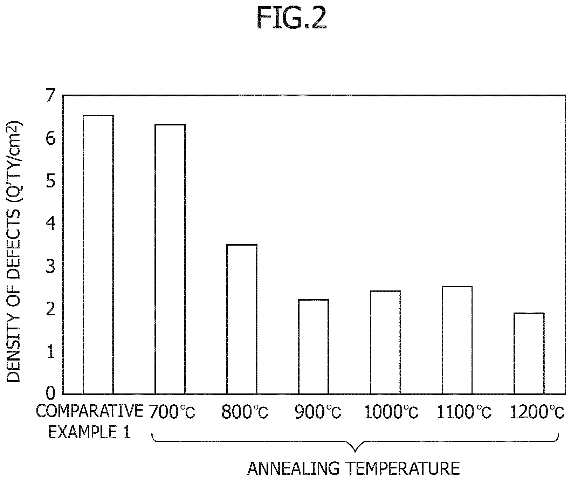

A plurality of the SOQ wafers used in Comparative Example 1 was provided. The mirror polishing (CMP) was carried out until the thickness of the single-crystal silicon films reached 60 nm. After the wafers were cleaned and dried, an amorphous silicon layer of 40 nm was deposited by a SiH₄ gas at 560°C and at a pressure of 200 mTorr. Thereafter, heating was carried out for one hour at 700°C, 800°C, 900°C, 1000°C, 1100°C, and 1200°C, respectively. The wafers were subjected to the same HF solution immersion treatment as that in Comparative Example 1, and the number of defects was counted. The results are shown in FIG. 2 and Table 1.

**[Table 1]**

| | Comparative Example 1 | runs in Example 1 | | | | | |
|---|---|---|---|---|---|---|---|
| | | 700°C | 800°C | 900°C | 1000°C | 1100°C | 1200°C |
| Density of Defects (Q'ty/cm²) | 6.5 | 6.4 | 3.5 | 2.1 | 2.3 | 2.5 | 2 |

The results indicate that the heating at 700°C is not effective for reducing the number of defects, while the heating at 800°C or above is effective. However, deformation was observed in the wafer subjected to the heating at 1200°C, so that it was determined that 1200°C is not appropriate.

### (Example 2)

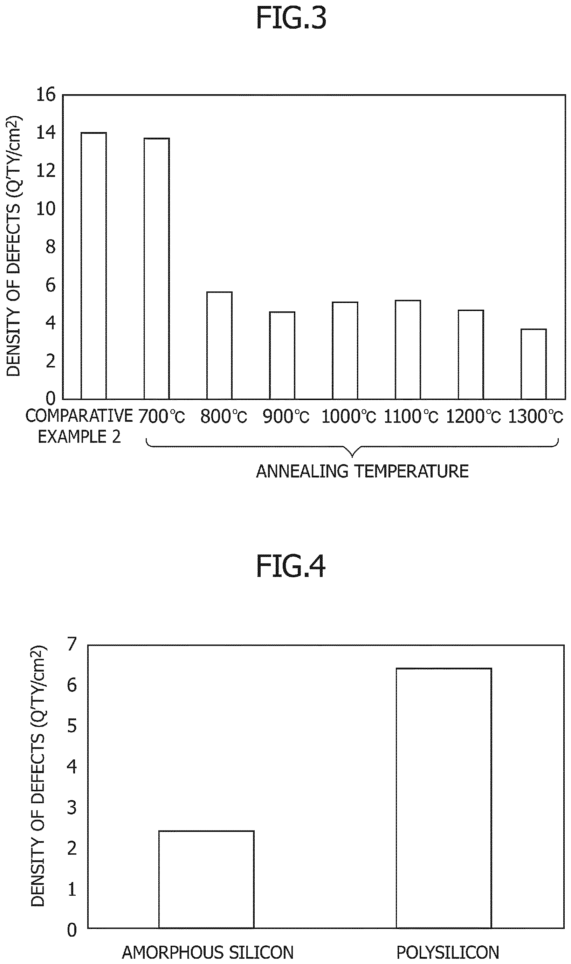

A plurality of the SOS wafers used in Comparative Example 2 was provided. The mirror polishing (CMP) was carried out until the thickness of the single-crystal silicon films reached 60 nm. After the wafers were cleaned and dried, an amorphous silicon layer of 40 nm was deposited by the SiH₄ gas at 560°C and at a pressure of 200 mTorr. Thereafter, heating was carried out for one hour at 700°C, 800°C, 900°C, 1000°C, 1100°C, 1200°C, and 1300°C, respectively. The wafers were subjected to the same HF solution immersion treatment as that in Comparative Example 2, and the number of defects was counted. The results are shown in FIG. 3 and Table 2.

**[Table 2]**

| | Comparative Example 2 | runs in Example 2 | | | | | | |
|---|---|---|---|---|---|---|---|---|
| | | 700°C | 800°C | 900°C | 1000°C | 1100°C | 1200°C | 1300°C |
| Density of Defects (Q'ty/cm²) | 14 | 13.8 | 5.6 | 4.6 | 5 | 5.2 | 4.8 | 4.1 |

The results indicate that the heating at 700°C is not effective for reducing the number of defects, while the heating at 800°C or above is effective. However, high contamination of aluminum (> 1×10¹³ atoms/cm²) was observed on the surface of the silicon layer of the wafer treated at 1300°C. The aluminum contamination of the rest was below 1×10¹²atoms/cm². As the measuring method, the inductively coupled plasma mass spectroscopy (ICP-MS) method was adopted. Although the defects can be repaired also by the heating at 1300°C or above for approximately one hour, such heating was determined to be inappropriate, because the aluminum from sapphire is considered to reach the silicon layer.

### (Comparative Example 3)

One SOQ wafer used in Comparative Example 1 was provided. The mirror polishing (CMP) was carried out until the thickness of the single-crystal silicon film reached 60 nm. After the wafer was cleaned and dried, a polysilicon layer of 40 nm deposited by the SiH₄ gas at 620°C and at a pressure of 200 mTorr. Thereafter, a heating was carried out for one hour at a temperature of 1000°C. The wafers were subjected to the same HF solution immersion treatment as that in Comparative Example 1, and the number of defects was counted. The results are shown in FIG. 4. The results indicate that the wafer has a greater number of defects, as compared with the wafer heated at 1000°C in Example 1. It is evident that the polysilicon film deposited is inappropriate.

### (Comparative Example 4)

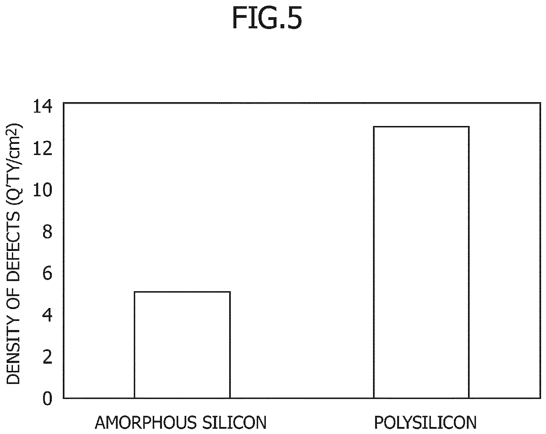

One SOS wafer used in Comparative Example 2 was provided. The mirror polishing (CMP) was carried out until the thickness of the single-crystal silicon film reached 60 nm. After the wafer was cleaned and dried, a polysilicon (mean particle size: 0.1 µm or less) layer of 40 nm was deposited by the SiH₄ gas at 620°C and at a pressure of 200 mTorr. The heating was carried out for one hour at a temperature of 1000°C. The wafers were subjected to the same HF solution immersion treatment as that in Comparative Example 1, and the number of defects was counted. The results are shown in FIG. 5. The results indicate that the wafer has a greater number of defects, as compared with the wafer heated at 1000 °C in Example 2. It is evident that the polysilicon film deposited is inappropriate.

### Description of reference numerals

- 1: SOQ, SOS or SOI wafer
- 3: handle substrate
- 5: single-crystal silicon layer
- 7: amorphous silicon
- 9: single-crystal silicon coating layer
- 10: bonded substrate

## Claims

1. A method for manufacturing an SOI wafer (1), comprising the steps of:
forming a single-crystal silicon layer (5) by a bonding method on a handle substrate (3) selected from a material having a heat-resistant temperature of 800°C or above to obtain a bonded substrate (10);
depositing amorphous silicon (7) on the single-crystal silicon layer (5) of the bonded substrate (10); and
heating the bonded substrate (1) after the depositing at 800°C or above to cause the amorphous silicon layer to crystallize in accordance with the orientation of the single crystal silicon layer, **characterized in that** the depositing of amorphous silicon on the single-crystal silicon layer of the bonded substrate is performed at a temperature of 540°C to 600°C

2. The method for manufacturing an SOI wafer (1) according to Claim 1, wherein the handle substrate (3) is a quartz substrate, and the heating temperature is below 1200°C.

3. The method for manufacturing an SOI wafer (1) according to Claim 1, wherein the handle substrate (3) is a sapphire substrate, and the heating temperature is below 1300°C.

4. The method for manufacturing an SOI wafer (1) according to Claim 1, wherein a material of the handle substrate (3) is silicon, silicon with an oxide film, silicon carbide, or aluminum nitride.

5. The method for manufacturing an SOI wafer (1) according to any one of Claims 1 to 4, wherein the step of depositing comprises low pressure chemical vapor deposition, physical vapor deposition, or plasma-enhanced chemical vapor deposition.

## Patentansprüche

1. Verfahren zur Herstellung eines SOI Wafers (1), umfassend die folgenden Schritte:
Ausformen einer Einzel-Kristall Siliziumschicht (5) durch ein Bindungsverfahren auf einem Verarbeitungssubstrat (3) ausgewählt aus einem Material, welches eine Hitze-Beständigkeitstemperatur von 800°C oder höher besitzt, um ein gebundenes Substrat (10) zu erhalten;
Ablagern von amorphem Silizium (7) auf die Einzel-Kristall Siliziumschicht (5) des gebundenen Substrats (10); und
Erhitzung des gebundenen Substrats (10) nach der Ablagerung bei 800°C oder höher um die amorphe Siliziumschicht zur Kristallisation zu veranlassen gemäß der Orientierung der Einzel-Kristall Siliziumschicht, **dadurch gekennzeichnet, dass** das Ablagern des amorphen Siliziums auf der Einzel-Kristall Siliziumschicht bei einer Temperatur von 540°C bis 600°C durchgeführt wird.

2. Verfahren zur Herstellung eines SOI Wafers (1) nach Anspruch 1, wobei das Verarbeitungssubstrat (3) ein Quarz-Substrat ist und die Erhitzungstemperatur unter 1200°C liegt.

3. Verfahren zur Herstellung eines SOI Wafers (1) nach Anspruch 1, wobei das Verarbeitungssubstrat (3) ein Saphir-Substrat ist und die Erhitzungstemperatur bei unter 1300°C liegt.

4. Verfahren zur Herstellung eines SOI Wafers (1) nach Anspruch 1, wobei das Material des Verarbeitungssubstrats (3) Silizium, Silizium mit einem Oxid-Film, Siliziumkarbid oder Aluminiumnitrid ist.

5. Verfahren zur Herstellung eines SOI Wafers (1) nach einem der Ansprüche 1 bis 4, wobei der Schritt des Ablagerns eine chemische Niederdruck-Gasphasenabscheidung, physikalische Gasphasenabscheidung oder Plasma-unterstützte chemische Gasphasenabscheidung umfasst.

## Revendications

1. Procédé de fabrication d'une tranche SOI (1), comprenant les étapes de :
formation d'une couche de silicium monocristallin (5) par un procédé de liaison sur un substrat de manipulation (3) choisi parmi un matériau ayant une température de résistance à la chaleur de 800 °C ou plus pour obtenir un substrat lié (10) ;
dépôt de silicium amorphe (7) sur la couche de silicium monocristallin (5) du substrat lié (10) ; et
chauffage du substrat lié (1) après le dépôt à 800 °C ou plus pour amener la couche de silicium amorphe à cristalliser selon l'orientation de la couche de silicium monocristallin, **caractérisé en ce que** le dépôt de silicium amorphe sur la couche de silicium monocristallin du substrat lié est effectué à une température de 540 °C à 600 °C.

2. Procédé de fabrication d'une tranche SOI (1) selon la revendication 1, dans lequel le substrat de manipulation (3) est un substrat en quartz, et la température de chauffage est inférieure à 1200 °C.

3. Procédé de fabrication d'une tranche SOI (1) selon la revendication 1, dans lequel le substrat de manipulation (3) est un substrat en saphir, et la température de chauffage est inférieure à 1300 °C.

4. Procédé de fabrication d'une tranche SOI (1) selon la revendication 1, dans lequel le matériau du substrat de manipulation (3) est du silicium, du silicium avec un film d'oxyde, du carbure de silicium ou du nitrure d'aluminium.

5. Procédé de fabrication d'une tranche SOI (1) selon l'une quelconque des revendications 1 à 4, dans lequel l'étape de dépôt comprend un dépôt chimique en phase vapeur basse pression, un dépôt physique en phase vapeur ou un dépôt chimique en phase vapeur assisté par plasma.
